# EUROPEAN PATENT SPECIFICATION

(11) **EP 2 961 007 B1**
(45) Date of publication and mention of the grant of the patent: **08.08.2018**
(21) Application number: 15173842.4
(22) Date of filing: 25.06.2015
(51) Int. Cl.: H01R 13/658, H05K 1/18, H05K 9/00, H01R 24/58, H04M 1/02

(54) **HEADPHONE SOCKET ASSEMBLY AND ELECTRONIC EQUIPMENT**
KOPFHÖRERBUCHSENANORDNUNG UND ELEKTRONISCHE AUSRÜSTUNG
ENSEMBLE DE PRISE DE CASQUE D'ECOUTE ET EQUIPEMENT ELECTRONIQUE

(30) Priority: 27.06.2014 CN 201410302988
(43) Date of publication of application: 30.12.2015
(73) Proprietor: Xiaomi Inc., Beijing 100085 (CN)
(72) Inventor: SUN, Wei, 100085 BEIJING (CN); GUO, Feng, 100085 BEIJING (CN); LEI, Zhenfei, 100085 BEIJING (CN)
(74) Representative: Fontenelle, Sandrine

(56) References cited:
- EP-A2- 1 096 757
- EP-A2- 2 590 273
- WO-A1-2011/150403
- US-A1- 2007 119 620
- US-A1- 2007 178 771

## Description

### TECHNICAL FIELD

The present invention relates to the field of electronic equipment technology, and more particularly, to a headphone socket assembly and an electronic equipment.

### BACKGROUND

In a mobile terminal, a headphone socket is prone to suffer electromagnetic interference from an antenna because the distance therebetween is short.

In order to reduce the electromagnetic interference suffered by the headphone socket from the antenna, relevant art provides a solution of installing a filter circuit before the headphone socket, which is able to filter the electromagnetic interference when it passes through the filter circuit, so as to achieve the object of reducing the electromagnetic interference suffered by the headphone socket from the antenna.

In a course of designing the present invention, the inventor found the following disadvantageous in the relevant art: the filter circuit can only filter the electromagnetic interference received before the filter circuit, but cannot filter the electromagnetic interference received after the filter circuit. Therefore, in the above solution, the headphone socket still undergoes the electromagnetic interference from the antenna. Document WO 2011/150403 A1 dated 1 December 2011 discloses a dual orientation connector having a connector tab with first and second major opposing sides and a plurality of electrical contacts carried by the connector tab.
Document EP 2590273 A2 dated 8 May 2013 discloses a dual orientation electronic connector with external contacts.
Document US 2007/178771 A1 dated 2 August 2007 discloses a connector system for coupling to an audio jack of an audio player.
Document EP 1 096 757 A2 discloses an earphone jack that is fixed on a printed circuit board by soldering as well as holding ribs.
Document US 2007/119620 A1 discloses a system for shielding at least one electrical component by using a flexible shielding circuit.

### SUMMARY

The present invention is defined in the appended claim 1 and preferred embodiments are defined in the appended dependent claims.

In order to solve the problem in the relevant art that the headphone socket is undergoing the electromagnetic interference from the antenna, the present invention provides a headphone socket assembly according to claim 1.

According to a first embodiment of the present invention, a headphone socket assembly is provided. The headphone socket assembly includes:
a headphone socket and an electromagnetic shield device;
the headphone socket is electrically connected to a circuit board in an electronic equipment; and
the electromagnetic shield device is disposed at a periphery of the headphone socket.

The headphone socket assembly further comprising a connector,wherein pins of the headphone socket are electrically connected to a conductive track on the circuit board via the connector; and wherein the electromagnetic shield device is an electromagnetic shielding layer which covers the periphery of the headphone socket such that said headphone socket is shielded from electromagnetic radiation generated by any other electric device in the circuit board ;the electromagnetic shielding layer being a Flexible Printed Circuit board (FPC) coated with electromagnetic shielding material.

According to the second embodiment of the present invention, the headphone socket is welded on the shielding layer; the connector comprising a first connector part welded on the shielding layer and a second connector part welded on the circuit board, wherein said first and second connector parts match each other so that, when said first and second connector parts are connected to each other, the connector connect the headphone socket to the circuit board.

The technical solutions according to embodiments of the invention have the following advantages:
The headphone socket is provided with the electromagnetic shield device at a periphery thereof, and is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at the periphery of the headphone socket, thus preventing the headphone socket from being affected by electromagnetic interference.

### BRIEF DESCRIPTION OF THE DRAWINGS

The accompanying drawings, which are incorporated in and constitute a part of this specification, illustrate embodiments and examples consistent with the invention and, together with the description, serve to explain the principles of the invention.
Fig. 1 is a structural diagram of a headphone socket assembly according to an exemplary embodiment.
Fig. 2A is a structural diagram of a headphone socket assembly according to another exemplary embodiment.
Fig. 2B is a structural diagram of a headphone socket in connection to a circuit board according to another exemplary embodiment.
Fig. 2C is a diagram of a welding manner of a headphone socket in the circuit board according to another exemplary embodiment.
Fig. 2D is a diagram of a welding manner of an electromagnetic shielding case in the circuit board according to another exemplary embodiment.
Fig. 3A is a structural diagram of a headphone socket assembly according to the first embodiment.
Fig. 3B is a structural diagram of a headphone socket in connection to a circuit board according to the first embodiment.
Fig. 3C is a structural diagram of a connector used for connecting a headphone socket assembly to a circuit board according to another exemplary embodiment.
Fig. 4 is a structural diagram of an electronic equipment according to an exemplary embodiment.
Fig. 5 is a structural diagram of an electronic equipment according to another exemplary embodiment.
Fig. 6 is a structural diagram of an electronic equipment according to still another embodiment.

### DETAILED DESCRIPTION

Reference will now be made in detail to embodiments and examples which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

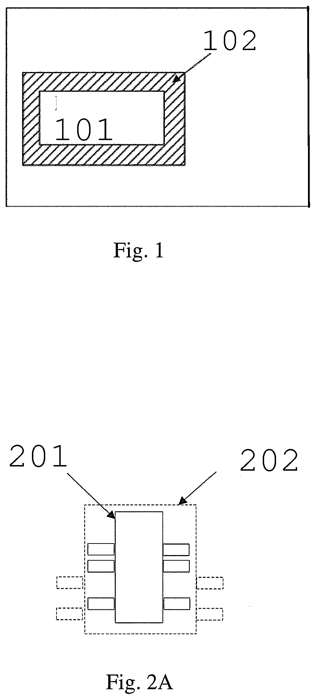

Fig. 1 is a structural diagram of a headphone socket assembly according to an exemplary embodiment. Referring to Fig. 1, the headphone socket assembly may include a headphone socket 101 and an electromagnetic shield device 102.

The headphone socket 101 is electrically connected to a circuit board in an electronic equipment.

Concerning an electronic equipment allowed to externally connect a wired headphone, it is commonly necessary to mount the headphone socket 101 corresponding to the wired headphone. In addition, in order to enable the electronic equipment to control the headphone socket 101 so as to control the wired headphone, the headphone socket 101 may be electrically connected to the circuit board in the electronic equipment.

The electronic equipment may be one such as mobile phone, panel PC, electronic reader, MP3 player (Moving Picture Experts Group Audio Layer III), MP4 (Moving Picture Experts Group Audio Layer IV) player, laptop, etc..

The electromagnetic shield device 102 is disposed at a periphery of the headphone socket 101.

In order to shield the electromagnetic radiation generated by electric devices in the circuit board, thus reducing electromagnetic interference received by the headphone socket 101, the electromagnetic shield device 102 may be disposed at a periphery of the headphone socket 101.

In conclusion, according to the headphone socket assembly provided in the embodiment of the present invention, the headphone socket is provided with the electromagnetic shield device at a periphery thereof, and is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at the periphery of the headphone socket, thus preventing the headphone socket from being affected by electromagnetic interference.

Pins of the headphone socket may be electrically connected to a conductive track on the circuit board in a manner of welding points or in a manner of connector in the headphone socket assembly. Hereafter, the above two manners will be described in two embodiments respectively.

Fig. 2A is a structural diagram of a headphone socket assembly according to an exemplary embodiment. This embodiment is described with the example that the headphone socket is electrically connected to a conductive track on the circuit board via welding points. Referring to Fig. 2A, the headphone socket assembly may include a headphone socket 201 and an electromagnetic shield device 202.

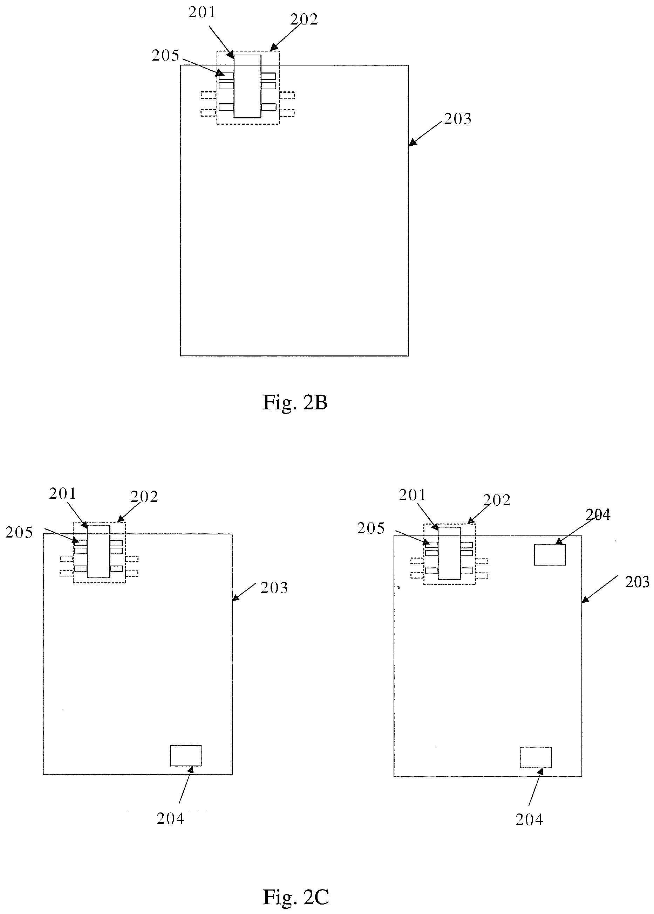

Referring to Fig. 2B, the headphone socket 201 is electrically connected to a circuit board 203 in an electronic equipment.

Concerning an electronic equipment allowed to externally connect a wired headphone, it is commonly necessary to mount the headphone socket 201 corresponding to the wired headphone. In addition, in order to enable the electronic equipment to control the headphone socket 201 so as to control the wired headphone, the headphone socket 201 may be electrically connected to the circuit board 203 in the electronic equipment. The electronic equipment may be one such as mobile phone, panel PC, electronic reader, MP3 player, MP4 player, laptop, etc. The circuit board 203 may include a plurality of electric devices, such as at least one antenna 204 (e.g. as represented on figure 2C), power amplifier, resistance, capacitance, loudspeaker, and so on.

In the present example, the headphone socket 201 may be directly welded in the circuit board 203, that is, pins 205 of the headphone socket 201 may be electrically connected to the conductive track on the circuit board 203 by welding points.

Moreover, depending on different positions connecting the wired headphone on the electric equipment, the headphone socket 201 may be welded on any side of the circuit board 203. For example, the headphone socket 201 is welded on the top side of the circuit board 203 shown in Fig. 2B.

During practical operation, in order to reduce electromagnetic interference suffered by the headphone socket 201 from other electric devices in the circuit board 203, the headphone socket 201 is usually welded at a position far away from each electric device. In particular, the antenna 204 usually generates large electromagnetic radiation, that is, the antenna 204 causes large electromagnetic interference to the headphone socket 201, therefore, the headphone socket 201 is usually welded at a position far away from the antenna 204 in the circuit board 203. Referring to Fig. 2C, positions for welding the headphone socket 201 are exemplarily shown in the case that one antenna 204 or two antennas 204 are provided in the circuit board 203.

The electromagnetic shield device 202 is disposed at a periphery of the headphone socket 201.

In the present example, the electromagnetic shield device 202 may be an electromagnetic shielding case. In order to shield the electromagnetic radiation generated by electric devices in the circuit board 203, thus reducing electromagnetic interference suffered by the headphone socket 201, the electromagnetic shielding case covers the periphery of the headphone socket 201 and of the welding points 205 of the headphone socket 201 on the circuit board 203, and is grounded through the circuit board 203.

During practical operation, in order to reduce the dimension of the electromagnetic shielding case, thus reducing the area occupied by the electromagnetic shielding case welded on the circuit board 203 and reducing cost for manufacturing the electromagnetic shielding case, the electromagnetic shielding case only needs to completely cover the headphone socket 201 and the welding points 205 of the headphone socket 201 on the circuit board 203, without need of providing larger dimension of electromagnetic shielding case.

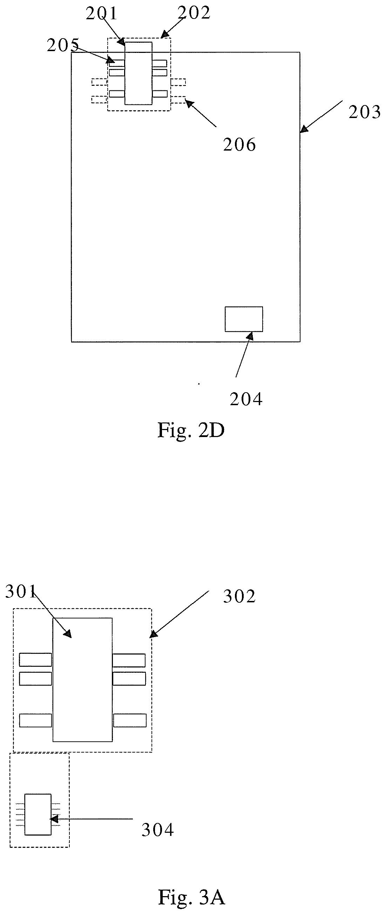

Furthermore, referring to Fig. 2D, the electromagnetic shielding case may be grounded via four pins 206 welded on the circuit board 203.

The electromagnetic shield device 202 is disposed at a periphery of the headphone socket 201, such that all of the electromagnetic radiation generated by electric devices in the circuit board 203 can be shielded by the electromagnetic shielding case, the headphone socket 201 in the electromagnetic shielding case is avoided from suffering electromagnetic interference, therefore, the problem that the headphone socket 201 is undergoing the electromagnetic interference from each electric device in the circuit board 203 can be solved.

It should be noted that, in the above solution, the electromagnetic shielding case is disposed at a periphery of the headphone socket 201, which is capable of shielding the electromagnetic radiation generated by each electric device, therefore, when welding the headphone socket 201 in the technical solution of the present embodiment, the headphone socket 201 may be welded at any position on the circuit board 203 without considering the distance between the headphone socket 201 and other electric devices, such as the antenna.

In conclusion, according to the headphone socket assembly provided in the embodiment of the present invention, the headphone socket is provided with the electromagnetic shield device at a periphery thereof, and is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at a periphery of the headphone socket, thus preventing the headphone socket from being affected by electromagnetic interference.

Fig. 3A is a structural diagram of a headphone socket assembly according to the first embodiment. This embodiment is described with the example that the headphone socket is electrically connected to a conductive track on the circuit board through a connector. Referring to Fig. 3A, the headphone socket assembly includes a headphone socket 301 and an electromagnetic shield device 302.

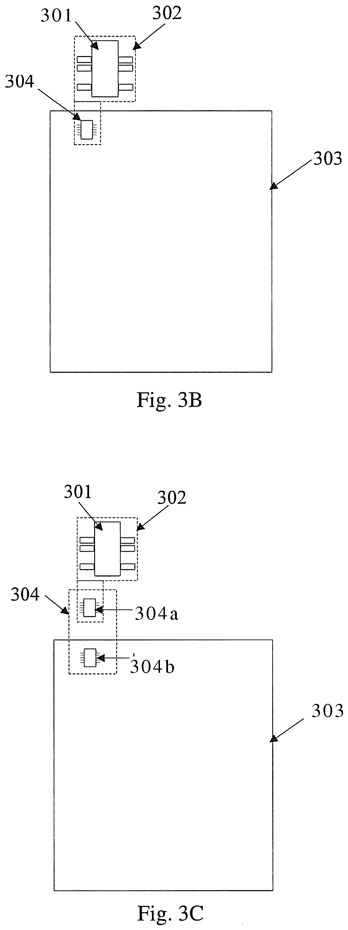

Referring to Fig. 3B, the headphone socket 301 is electrically connected to a circuit board 303 in an electronic equipment.

Concerning an electronic equipment allowed to externally connect a wired headphone, it is commonly necessary to mount the headphone socket 301 corresponding to the wired headphone. In addition, in order to enable the electronic equipment to control the headphone socket 301 so as to control the wired headphone, the headphone socket 301 is electrically connected to the circuit board 303 in the electronic equipment. The electronic equipment may be one such as mobile phone, panel PC, electronic reader, MP3 player, MP4 player, laptop, etc. The circuit board 303 may include a plurality of electric devices, such as at least one antenna, power amplifier, resistance, capacitance, loudspeaker, and so on.

Referring to Fig. 3C, in a possible implemental manner according to the embodiment, the headphone socket assembly may further include a connecter 304 through which the pins of the headphone socket 301 are electrically connected to the conductive track on the circuit board 303. During practical operation, the connector 304 may include two parts matched with each other. Each pin of a first part 304a is correspondingly connected to the pin of the headphone socket 301, and each pin of a second part 304b is welded to the conductive track on the circuit board 303. After the first part 304a and second part 304b of the connector 304 are matched and connected, it is realized that the pins of the headphone socket 301 are electrically connected to the conductive track on the circuit board 303 through the connector 304.

The electromagnetic shield device 302 is disposed at a periphery of the headphone socket 301.

In the present embodiment, the electromagnetic shield device 302 may be an electromagnetic shielding layer. In order to shield the electromagnetic radiation generated by electric devices in the circuit board 303, thus reducing electromagnetic interference suffered by the headphone socket 301, the electromagnetic shielding layer may cover the periphery of the headphone socket 301.

The headphone socket 301 is covered by the electromagnetic shielding layer, such that all of the electromagnetic radiation generated by each electric device in the circuit board can be shielded by the electromagnetic shielding layer disposed at a periphery of the headphone socket 301. The problem that the headphone socket 301 is undergoing the electromagnetic interference from each electric device in the circuit board can be solved.

Additionally according to the embodiment, the electromagnetic shielding layer may be a FPC (Flexible Printed Circuit board) coated with electromagnetic shielding material. The headphone socket 301 may be welded on the FPC and then covered by the FPC, such that the headphone socket 301 covered by the FPC is able to avoid to be affected by electromagnetic interference from each electric device in the circuit board 303, because a surface of the FPC is coated with shielding material. Referring to Fig. 3C, the first part 304a of the connector 304 may be welded on the FPC, and the second part 304b of the connector 304 may be welded on the circuit board 303. After the first part of the connector in the FPC and second part of the connector in the circuit board are matched and connected, it is realized that the headphone socket 301 is electrically connected to the circuit board through the connector. Fig. 3A illustrates the diagram of the matched connection.

It should be noted that, this embodiment is described with the example that the connector 304 includes 10 pins. During practical operation, the connector 304 may include less or more pins, and the connector 304 needs only to include pins corresponding to 6 pins of the headphone socket 301. The number of pins of the connector 304 is not limited by the embodiment.

In conclusion, according to the headphone socket assembly provided in the embodiment of the present invention, the headphone socket is provided with the electromagnetic shield device at a periphery thereof, and is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at a periphery of the headphone socket, thus preventing the headphone socket from being affected by electromagnetic interference.

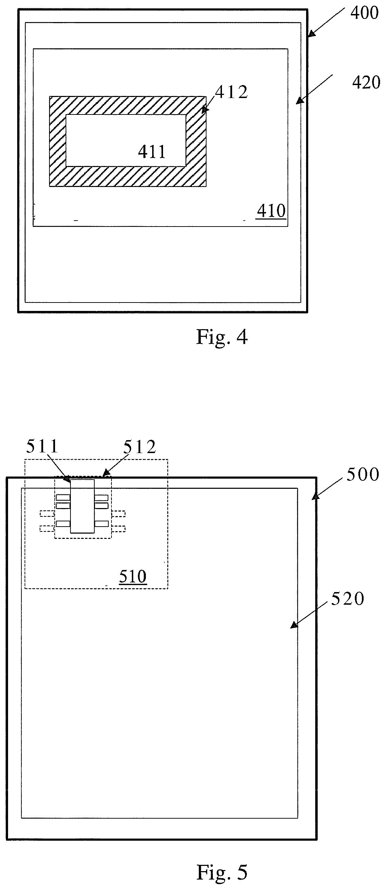

Fig. 4 is a structural diagram of an electronic equipment 400 according to an exemplary embodiment. Referring to Fig. 4, the electronic equipment 400 may include a headphone socket assembly 410 and a circuit board 420.

The headphone socket assembly 410 may include a headphone socket 411 and an electromagnetic shield device 412.

The headphone socket 411 is electrically connected to the circuit board 420 in the electronic equipment.

The electromagnetic shield device 412 is disposed at a periphery of the headphone socket 411.

It should be noted that, the headphone socket assembly 410 in the present example is similar with the headphone socket assembly as shown in Fig. 1. For the technical details of the headphone socket assembly please refer to the above embodiment, and the detailed description is omitted herein.

In conclusion, the electronic equipment according to the present example includes the headphone socket assembly, the headphone socket is provided with the electromagnetic shield device at a periphery thereof, and the headphone socket is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at a periphery of the headphone socket, thus preventing the headphone socket from being affected by electromagnetic interference.

Pins of the headphone socket in the headphone socket assembly may be electrically connected to a conductive track on the circuit board in a manner of welding points or in a manner of connector. Hereafter, the above two manners will be described in two embodiments respectively.

Fig. 5 is a structural diagram of an electronic equipment 500 according to an exemplary embodiment. This embodiment is described with the example that the headphone socket in the headphone socket assembly is electrically connected to a conductive track on the circuit board via welding points. The electronic equipment 500 may include a headphone socket assembly 510 and a circuit board 520.

The headphone socket assembly 510 includes a headphone socket 511 and an electromagnetic shield device 512.

The headphone socket 511 is electrically connected to the circuit board 520 in the electronic equipment.

The electromagnetic shield device 512 is disposed at a periphery of the headphone socket 511.

In a first possible implemental manner according to the example pins of the headphone socket 511 are electrically connected to the conductive track on the circuit board 520 via welding points.

The electromagnetic shield device 512 is an electromagnetic shielding case which covers the periphery of the headphone socket and of the welding points of the headphone socket on the circuit board, and which is grounded through the circuit board.

In a second possible implemental manner according to the example the headphone socket 511 is disposed on any side of the circuit board 520. The circuit board 520 is provided with at least one antenna (not represented on the figure).

It should be noted that, the headphone socket assembly 510 in the present example is similar with the headphone socket assembly as shown in Fig. 2A. For the technical details of the headphone socket assembly please refer to the above example and the detailed description is omitted herein.

In conclusion, the electronic equipment according to the present example includes the headphone socket assembly, the headphone socket is provided with the electromagnetic shield device at a periphery thereof, and the headphone socket is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at a periphery of the headphone socket, thus preventing the headphone socket from being affected by electromagnetic interference.

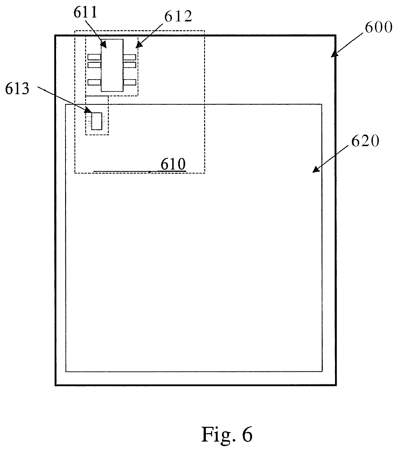

Fig. 6 is a structural diagram of an electronic equipment 600 according to another embodiment. This embodiment is described with the example that the headphone socket of the headphone socket assembly is electrically connected to a conductive track on the circuit board via welding points. The electronic equipment 600 may include a headphone socket assembly 610 and a circuit board 620.

The headphone socket assembly includes a headphone socket 611 and an electromagnetic shield device 612.

The headphone socket 611 is electrically connected to the circuit board 620 in the electronic equipment.

The electromagnetic shield device 612 is disposed at a periphery of the headphone socket 611.

In a first possible implemental manner according to the embodiment, the headphone socket assembly may further include a connector 613.

Pins of the headphone socket 611 are electrically connected to the conductive track on the circuit board 620 via the connector 613.

The electromagnetic shield device 612 is an electromagnetic shielding layer which covers the periphery of the headphone socket 611.

In a second possible implemental manner according to the embodiment, the electromagnetic shielding layer is a Flexible Printed Circuit board (FPC) coated with electromagnetic shielding material.

It should be noted that, the headphone socket assembly 610 in the present embodiment is similar with the headphone socket assembly as shown in Fig. 3A. For the technical details of the headphone socket assembly please refer to the above embodiment, and the detailed description is omitted herein.

In conclusion, the electronic equipment according to the present embodiment includes the headphone socket assembly, the headphone socket is provided with the electromagnetic shield device at a periphery thereof, and the headphone socket is connected to the circuit board in the electronic equipment, such that the headphone socket is avoided to be affected by electromagnetic interference from each electric device in the circuit board. The problem in the relevant art that the headphone socket is undergoing the electromagnetic interference from the antenna can be solved, and electromagnetic radiation generated by each electric device in the circuit board can be shielded by the electromagnetic shield device disposed at a periphery of the headphone socket, thus preventing the headphone socket from being affected by electromagnetic interference.

It will be appreciated that the present invention is not limited to the exact construction that has been described above and illustrated in the accompanying drawings. It is intended that the scope of the invention only be limited by the appended claims.

## Claims

1. A headphone socket assembly, the headphone socket assembly comprises:
a headphone socket (301) and an electromagnetic shield device (302);
wherein the headphone socket is electrically connected to a circuit board (303) in an electronic equipment (600); and
wherein the electromagnetic shield device (302) is disposed at a periphery of the headphone socket,
the headphone socket assembly further comprising a connector (304),
wherein pins of the headphone socket are electrically connected to a conductive track on the circuit board via the connector (304); and **characterized in that** the electromagnetic shield device (302) is a Flexible Printed Circuit board coated with electromagnetic shielding material
which covers the periphery of the headphone socket such that said headphone socket is shielded from electromagnetic radiation generated by any other electric device in the circuit board.

2. The headphone socket assembly according to claim 1, wherein the headphone socket (301) is welded on the shielding layer; said connector (304) comprising a first connector part (304a) welded on the shielding layer and a second connector part (304b) welded on the circuit board 303, wherein said first and second connector parts match each other so that, when said first and second connector parts are connected to each other, the connector (304) connect the headphone socket (301) to the circuit board (303).

3. An electronic equipment (600), **characterized in that** the electronic equipment comprises:
a headphone socket assembly (410,510,610) according to claim 1 or 2; and
a circuit board (620) arranged to be connected with said headphone socket assembly via the connector (304) of the headphone socket (301).

## Patentansprüche

1. Kopfhörerbuchsenanordnung, wobei die Kopfhörerbuchsenanordnung umfasst:
eine Kopfhörerbuchse (301) und eine elektromagnetische Abschirmvorrichtung (302),
wobei die Kopfhörerbuchse mit einer Leiterplatte (303) in einer elektronischen Einrichtung (600) elektrisch verbunden ist und
wobei die elektromagnetische Abschirmvorrichtung (302) an einem Umfang der Kopfhörerbuchse angeordnet ist,
wobei die Kopfhörerbuchsenanordnung ferner einen Verbinder (304) aufweist,
wobei Stifte der Kopfhörerbuchse über den Verbinder (304) elektrisch mit einer Leiterbahn auf der Leiterplatte verbunden sind,
und **dadurch gekennzeichnet, dass**
die elektromagnetische Abschirmvorrichtung (302) eine flexible gedruckte Leiterplatte ist, die mit einem elektromagnetischen Abschirmmaterial überzogen ist, das den Umfang der Kopfhörerbuchse so bedeckt, dass die Kopfhörerbuchse von einer elektromagnetischen Strahlung abgeschirmt ist, die durch irgendeine andere elektrische Vorrichtung in der Leiterplatte erzeugt wird.

2. Die Kopfhörerbuchsenanordnung nach Anspruch 1, wobei die Kopfhörerbuchse (301) an die Abschirmschicht geschweißt ist,
wobei der Verbinder (304) einen ersten Verbinderteil (301a), der an die Abschirmschicht geschweißt ist, und einen zweiten Verbinderteil (304b) umfasst, der an die Leiterplatte (303) geschweißt ist, wobei der erste und zweite Verbinderteil so zueinander passen, dass wenn der erste und zweite Verbinderteil miteinander verbunden sind, der Verbinder (301) die Kopfhörerbuchse (301) mit der Leiterplatte (303) verbindet.

3. Elektronische Einrichtung (600), **dadurch gekennzeichnet, dass** die elektronische Einrichtung umfasst:
eine Kopfhörerbuchsenanordnung (410,510,610) nach Anspruch 1 oder 2, und
eine Leiterplatte (620), die eingerichtet ist, über den Verbinder (304) der Kopfhörerbuchse (301) mit der Kopfhörerbuchsenanordnung verbunden zu werden.

## Revendications

1. Ensemble de prise de casque d'écoute, l'ensemble de prise de casque d'écoute comprend :
une prise de casque d'écoute (301) et un dispositif de protection électromagnétique (302) ;
dans lequel la prise de casque d'écoute est électriquement raccordée à une carte de circuit imprimé (301) dans un équipement électronique (600) ; et
dans lequel le dispositif de protection électromagnétique (302) est disposé à une périphérie de la prise de casque d'écoute,
l'ensemble de prise de casque d'écoute comprenant en outre un connecteur (304),
dans lequel des broches de la prise de casque d'écoute sont électriquement raccordées à un chemin conducteur sur la carte de circuit imprimé via le connecteur (304) ; et **caractérisé en ce que** :
le dispositif de protection électromagnétique (302) est une carte de circuit imprimé flexible recouverte avec un matériau de protection électromagnétique qui recouvre la périphérie de la prise de casque d'écoute de sorte que ladite prise de casque d'écoute est protégée contre le rayonnement électromagnétique généré par n'importe quel autre dispositif électrique dans la carte de circuit imprimé.

2. Ensemble de prise de casque d'écoute selon la revendication 1, dans lequel prise de casque d'écoute (301) est soudée sur la couche de protection ;
ledit connecteur (304) comprenant une première partie de connecteur (304a) soudée sur la couche de protection et une seconde partie de connecteur (304b) soudée sur la carte de circuit imprimé (303), dans lequel lesdites première et seconde parties de connecteur correspondent l'une à l'autre de sorte que, lorsque lesdites première et seconde parties de connecteur sont raccordées entre elles, le connecteur (304) raccorde la prise de casque d'écoute (301) à la carte de circuit imprimé (303).

3. Equipement électronique (600), **caractérisé en ce que** l'équipement électronique comprend :
un ensemble de prise de casque d'écoute (410, 510, 610) selon la revendication 1 ou 2 ; et
une carte de circuit imprimé (620) agencée pour être raccordée avec ledit ensemble de prise de casque d'écoute via le connecteur (304) de la prise de casque d'écoute (301).
